# EUROPÄISCHE PATENTANMELDUNG

(11) **EP 1 854 674 A1**
(43) Veröffentlichungstag der Anmeldung: **14.11.2007**
(21) Anmeldenummer: 06009915.7
(22) Anmeldetag: 13.05.2006
(51) Int. Cl.: B60R 16/02

(54) **Kraftfahrzeug mit einer Audioanlage**

(71) Anmelder: GM Global Technology Operations, Inc., Detroit, MI 48265-3000 (US)
(72) Erfinder: Hubertus, Guido, 65239 Hochheim (DE); Wolf, Holger, 55270 Essenheim (DE)
(74) Vertreter: Daniel, Ulrich W.P.

(57) **Zusammenfassung**

Ein Kraftfahrzeug weist eine Audioanlage und eine Einrichtung zur Ausgabe eines akustischen Warnsignals auf. Um das akustische Warnsignal zuverlässig hören zu können, wird bei Ausgabe des Warnsignals die Audioanlage in ihrer Lautstärke reduziert.

## Beschreibung

Die Erfindung bezieht sich auf ein Kraftfahrzeug mit einer Audioanlage und einer Einrichtung zur Ausgabe eines akustischen Warnsignals.

Moderne Kraftfahrzeuge verfügen über eine Audianlage mit einem Radioempfänger zum Empfang von Unterhaltungsprogrammen und insbesondere von Verkehrsnachrichten. Weiterhin kann die Audioanlage einen CD-Spieler, ein Kassettenabspielgerät oder sonstige Audioquellen umfassen. Es ist bekannt, ein Mobiltelefon über eine Freisprechanlage derart mit der Audioanlage zu verbinden, dass bei einem ein- oder ausgehenden Telefonanruf die Audioanlage stumm geschaltet wird, um ungestört von Hintergrundgeräuschen telefonieren zu können.

Zur Erhöhung der Verkehrssicherheit ist ein Kraftfahrzeug in der Regel mit einer Einrichtung zur Ausgabe eines akustischen Warnsignals ausgestattet. Ist beispielsweise der Sicherheitsgurt des Fahrers während der Fahrt nicht korrekt angelegt, d.h. das Gurtschloss nicht geschlossen, wird eine Warnmitteilung, beispielsweise in Form eines Signaltons, ausgegeben, um den Fahrer auf diesen Umstand hinzuweisen. Ebenso können Warnsignale ausgegeben werden, falls eine Tür nicht korrekt geschlossen ist, ein Abblendlicht trotz abgezogenem Zündschlüssel nicht ausgeschaltet ist oder für einen nicht auf Neutralstellung zurückgestellten Fahrtrichtungsanzeiger.

Die DE 102 42 558 A1 beschreibt ein Audiosystem, insbesondere für ein Kraftfahrzeug, mit dem zwei unterschiedliche Audiosignale erzeugt werden können. Das zweite Audiosignal ist beispielsweise ein Warnsignal. Wird bei Ausgabe zweier sich überlagernder Audiosignale ein Lautstärkeeinstellorgan betätigt, so wird das eine Audiosignal in seiner Lautstärke angehoben und gleichzeitig das andere Audiosignal in seiner Lautstärke abgesenkt.

Im Weiteren offenbart die DE 100 27 558 A1 ein Kraftfahrzeug mit einer Belüftungsanlage und einem Autotelefon. Bei einem ein- oder ausgehenden Telefonanruf wird ein Lüfter in seiner Geschwindigkeit bzw. Drehzahl reduziert, um derart weniger Geräusche zu erzeugen, wodurch ein Nutzer ungestört telefonieren kann.

Darüber hinaus zeigt die DE 31 10 229 A1 einen Warngeräuschgenerator, dessen Warnsignale in Abhängigkeit eines Geräuschpegels im Innenraum des Kraftfahrzeugs gesteuert werden können. Fährt das Kraftfahrzeug schnell und im Innenraum treten laute Geräusche des Fahrtwinds auf, wird ein Warnsignal mit höherer Lautstärke abgegeben.

Aus der DE 198 27 197 A1 geht ein Audiowiedergabegerät in einem Kraftfahrzeug hervor, das mit Hilfe eines Mikrophons feststellen kann, ob sich Passagiere in einem Innenraum des Kraftfahrzeugs unterhalten. In diesem Fall wird das Audiowiedergabegerät in seiner Lautstärke leiser eingestellt, um eine ungestörte Unterhaltung der Passagiere zu ermöglichen.

Weiterhin ist aus der EP 1 067 682 B1 ein System für hörbare Sprachmeldungen in einem Kraftfahrzeug bekannt, mit dem ein Schallpegel im Innenraum des Kraftfahrzeugs erfassbar ist. Entsprechend diesem Schallpegel, der auch von einer Audioanlage verursacht sein kann, wird ein Warnsignal so laut eingestellt, dass es mindestens um eine vorbestimmte Solldifferenz lauter ist als der gemessene Schallpegel.

Schließlich offenbart die DE 30 32 286 A1 eine akustische Warneinrichtung für ein Kraftfahrzeug, mit der Warnmitteilungen ausgegeben werden können, deren Lautstärke dabei in Abhängigkeit ihrer Wichtigkeit geregelt wird. Ist beispielsweise eine Fahrzeugtür nicht korrekt geschlossen, wird eine lautere Warnmitteilung ausgegeben als bei einem nicht zurückgestellten Fahrtrichtungsanzeiger.

Die bekannten Kraftfahrzeuge mit einer Audioanlage sind insofern nachteilig, als bei einer laut eingestellten Audioanlage ein akustisches Warnsignal leicht überhört werden kann, selbst wenn dieses mit einer noch größeren Lautstärke ausgegeben wird. Dies kann potentiell zu einer verkehrsgefährdenden Situation führen, wenn beispielsweise eine Warnmitteilung für eine Glatteisgefahr überhört wird.

Es ist Aufgabe der Erfindung, ein Kraftfahrzeug der eingangs genannten Art zu schaffen, bei dem das Wahrnehmen einer Warnmitteilung zuverlässig gewährleistet ist.

Erfindungsgemäß wird die Aufgabe dadurch gelöst, dass bei Ausgabe des Warnsignals die Audioanlage in ihrer Lautstärke reduzierbar ist.

Wird von einem Steuergerät, vorzugsweise von einem zentralen Steuergerät des Kraftfahrzeugs zur Steuerung aller Funktionen, die Notwendigkeit zur Ausgabe eines akustischen Warnsignals festgestellt, so wird das Warnsignal in an sich bekannter Weise erzeugt und ausgegeben. Gleichzeitig wird eine im Kraftfahrzeug vorhandene Audioanlage derart angesteuert, dass ihre Lautstärke reduziert ist. Somit ist ein Überhören des akustischen Warnsignals praktisch ausgeschlossen. Der Fahrer oder sonstige Passagiere können aber weiterhin eine eventuell gerade eingehende Verkehrsnachricht hören, die vom Warnsignal überlagert wird, da die Lautstärke der Audioanlage nicht vollständig und je nach Art des Warnsignals auch nur kurzzeitig abgeregelt ist. Selbstverständlich sind beliebige Warnsignale ausgebbar, um auf verschiedene sicherheitsrelevante Umstände hinzuweisen. Ebenso können Signale von Fahrassistenzsystemen, wie beispielsweise einer Abstandsmesseinrichtung oder einer Parkhilfe zur Vermeidung von Unfällen und Kollisionen, bei einer leiser geschalteten Audioanlage ausgegeben werden. Die Audioanlage wird nur dann und nur so lange abgeregelt, wie tatsächlich Warnsignale ausgegeben werden.

Im Rahmen der Erfindung sind beliebige Einrichtungen zur Ausgabe eines akustischen Warnsignals mit umfasst, beispielsweise ein Airbagsensor, der eine Funktionsstörung eines Airbags feststellt und ein entsprechendes Signal an das Steuergerät weiterleitet. Die Einrichtung kann in das Steuergerät integriert sein. Zur Ausgabe des Warnsignals kann entweder ein eigener Lautsprecher dienen oder das Warnsignal wird über die Audioanlage ausgegeben.

Der Vorteil der Erfindung besteht darin, dass praktisch kaum zusätzlicher Aufwand für eine bessere Hörbarkeit eines auszugebenden Warnsignals betrieben werden muss. Die Audioanlage sowie die Einrichtung zur Ausgabe des Warnsignals sind bereits im Kraftfahrzeug vorhanden und stehen üblicherweise über bekannte Datenbus-Architekturen mit einem zentralen Steuergerät in Verbindung. Dieses muss lediglich hard- und/oder softwaremäßig derart ausgelegt sein, dass bei der Ausgabe bzw. einer Anforderung zur Ausgabe eines Warnsignals gleichzeitig die Lautstärke der Audioanlage reduziert wird.

Vorzugsweise wird nicht nur die Lautstärke einer Audioanlage verringert, sondern gleichzeitig auch die Lautstärke des Warnsignals gegenüber der ursprünglichen Lautstärke der Audioanlage erhöht. Somit ist ein noch größerer Lautstärkeunterschied zwischen dem Warnsignal und der quasi im Hintergrund laufenden Audioanlage erreicht, wodurch die Hörbarkeit des Warnsignals sichergestellt ist. Selbstverständlich darf die Lautstärke des Warnsignals einen Grenzwert nicht überschreiten, um keine Hörschädigungen hervorzurufen.

In weiterer Ausgestaltung ist ein Warnsignal in unterschiedlichen Lautstärken ausgebbar. Beispielsweise kann ein Warnsignal für eine offenstehende Tür mit einer größeren Lautstärke ausgegeben werden als ein Warnsignal für einen nicht zurückgestellten Fahrtrichtungsanzeiger.

Bevorzugt werden auch unterschiedliche Warnsignale, wie ein Pfeifen, ein Summen oder ein Intervallsignal, ausgegeben. Insbesondere wird eine Sprachmitteilung in entsprechender Lautstärke ausgegeben, um diese auch bei einer eingeschalteten, aber in ihrer Lautstärke reduzierten Audioanlage verstehen zu können.

Nach einer Weiterbildung wird ein Telefongespräch, das über die Audioanlage übertragen wird, in seiner Lautstärke reduziert, wenn während des Telefongesprächs ein Warnsignal ausgegeben wird. Dies kann zwar dazu führen, dass Teile des Telefongesprächs nicht verstanden werden, dies ist durch den Gewinn an Verkehrssicherheit aber gerechtfertigt.

Welche Warnmitteilungen mittels bestimmter Warnsignale bzw. mit unterschiedlichen Lautstärken ausgegeben werden sollen, kann entweder werksseitig vorgegeben oder vom Nutzer in gewünschter Weise eingestellt werden. Insbesondere werden hierbei Warnsignale, die auf eine akute Gefahrensituation, wie z.B. eine mögliche Glatteisgefahr, hinweisen mit hoher Priorität eingestuft, so dass diese Warnsignale mit besonders großer Lautstärke ausgegeben werden. Prinzipiell kann eine derartige Auswahl auch von einem Nutzer an einer Schnittstelle, beispielsweise eine menügeführte Darstellung auf einem Display, ausgewählt werden.

Es versteht sich, dass die vorstehend genannten Merkmale nicht nur in der jeweils angegebenen Kombination, sondern auch in anderen Kombinationen verwendbar sind. Der Rahmen der Erfindung ist nur durch die Ansprüche definiert.

## Patentansprüche

1. Kraftfahrzeug mit einer Audioanlage und einer Einrichtung zur Ausgabe eines akustischen Warnsignals, **dadurch gekennzeichnet, dass** bei Ausgabe des Warnsignals die Audioanlage in ihrer Lautstärke reduzierbar ist.

2. Kraftfahrzeug nach Anspruch 1, **dadurch gekennzeichnet, dass** eine Lautstärke des Warnsignals gegenüber der ursprünglichen Lautstärke der Audioanlage erhöhbar ist.

3. Kraftfahrzeug nach Anspruch 1 oder 2, **dadurch gekennzeichnet, dass** Warnsignale in unterschiedlichen Lautstärken ausgebbar sind.

4. Kraftfahrzeug nach einem der Ansprüche 1 bis 3, **dadurch gekennzeichnet, dass** unterschiedliche Warnsignale ausgebbar sind, insbesondere eine Sprachmitteilung.

5. Kraftfahrzeug nach einem der Ansprüche 1 bis 4, **dadurch gekennzeichnet, dass** ein über die Audioanlage übertragenes Telefongespräch in seiner Lautstärke reduzierbar ist.

6. Kraftfahrzeug nach einem der Ansprüche 1 bis 5, **dadurch gekennzeichnet, dass** eine Priorität eines Warnsignals einstellbar ist.

## Geänderte Patentansprüche

### Geänderte Patentansprüche gemäss Regel 86(2) EPÜ.

**1.** Kraftfahrzeug mit einem Steuergerät, einer Audioanlage und einer Einrichtung zur Ausgabe eines akustischen Warnsignals, **dadurch gekennzeichnet, dass** das Steuergerät bei Ausgabe des Warnsignals die Audioanlage in ihrer Lautstärke reduziert und eine Priorität eines Warnsignals werksseitig oder nutzerseitig einstellbar ist.

**2.** Kraftfahrzeug nach Anspruch 1, **dadurch gekennzeichnet, dass** eine Lautstärke des Warnsignals gegenüber der ursprünglichen Lautstärke der Audioanlage erhöhbar ist.

**3.** Kraftfahrzeug nach Anspruch 1 oder 2, **dadurch gekennzeichnet, dass** Warnsignale in unterschiedlichen Lautstärken ausgebbar sind.

**4.** Kraftfahrzeug nach einem der Ansprüche 1 bis 3, **dadurch gekennzeichnet, dass** unterschiedliche Warnsignale ausgebbar sind, insbesondere eine Sprachmitteilung.

**5.** Kraftfahrzeug nach einem der Ansprüche 1 bis 4, **dadurch gekennzeichnet, dass** ein über die Audioanlage übertragenes Telefongespräch in seiner Lautstärke reduzierbar ist.
